# EUROPÄISCHE PATENTSCHRIFT

(11) **EP 3 425 665 B1**
(45) Veröffentlichungstag und Bekanntmachung des Hinweises auf die Patenterteilung: **20.04.2022**
(21) Anmeldenummer: 18187935.4
(22) Anmeldetag: 18.07.2011
(51) Int. Cl.: H01L 23/49, H01L 23/00

(54) **VERFAHREN ZUR HERSTELLUNG EINES BONDDRAHTES**
METHOD FOR THE PRODUCTION OF A BONDING WIRE
PROCÉDÉ DE FABRICATION D'UN FILS DE CONNEXION

(30) Priorität: 22.07.2010 DE 102010031993
(43) Veröffentlichungstag der Anmeldung: 09.01.2019
(62) Teilanmeldung aus: 11749078.9
(73) Patentinhaber: Heraeus Deutschland GmbH & Co. KG, 63450 Hanau (DE)
(72) Erfinder: MILKE, Eugen, 61130 Nidderau (DE); DICK, Jürgen, 63486 Bruchköbel (DE); PRENOSIL, Peter, 63454 Hanau (DE); WULFF, Frank-Werner, verstorben (DE)
(74) Vertreter: Heraeus IP

(56) Entgegenhaltungen:
- WO-A1-2005/067040
- JP-A- 62 287 634
- JP-A- H02 211 646
- JP-A- 2004 128 216
- US-A1- 2009 079 042
- US-A1- 2010 107 717

## Beschreibung

Die vorliegende Erfindung betrifft ein Verfahren zur Herstellung eines Bonddrahts.

Bonddrähte werden in der Mikroelektronik häufig eingesetzt, um Halbleiterchips mit einem Trägersubstrat, wie zum Beispiel einem Verdrahtungsträger, elektrisch zu kontaktieren.

Zum Bonden werden üblicherweise runde Dünndrähte oder Dickdrähte eingesetzt, die sich in ihrem Querschnitt unterscheiden. Dünndrähte weisen einen Durchmesser im Bereich von 17 - 100 µm auf, während Dickdrähte durch Durchmesser von 100 - 500 µm gekennzeichnet sind.

In den letzten Jahren hat sich die Erkenntnis durchgesetzt, dass es in Abhängigkeit von der konkreten Verwendung von Vorteil sein kann, runde Bonddrähte einzusetzen, die aus mehreren Lagen oder Schichten unterschiedlichen Materials bestehen können.

So ist es beispielsweise aus der DE 42 32 745 bekannt, dass die Zuverlässigkeit des Ultraschallbondens erhöht werden kann, wenn hierfür Bonddrähte aus Gold oder Kupfer eingesetzt werden, die einen Mantel aus Aluminium aufweisen.

Die EP 1279491 wiederum schlägt aus Kostengründen vor, die Menge an Gold in Bonddrähten aus Kostengründen dadurch zu senken, dass statt reinen Golddrähten Bonddrähte aus Kupfer, Silber oder Palladium vorgesehen werden, die mit Gold beschichtet sind.

Gemäß der JP 62-97360 werden Bonddrähte aus Kupfer dadurch vor Oxidation geschützt, dass sie mit einer Schicht aus einem oxidationsstabilen Material überzogen werden.

Obwohl Bonddrähte mit einem runden Querschnitt, wie sie vorstehend beschrieben sind, für viele Anwendungen geeignet sind, hat sich daneben seit vielen Jahren der Einsatz von sogenannten Bändchendrähten etabliert. Diese sind dadurch gekennzeichnet, dass sie keinen runden Querschnitt, sondern einen elliptischen oder rechteckigen Querschnitt aufweisen, und vor allem für das Bonden in Leistungsbauteilen verwendet werden. Die größere, gleichzeitig aber flachere Geometrie der Bändchendrähte bietet den praktischen Vorteil der schnelleren Verarbeitung, da statt vielen dünneren Bonddrähten nur wenige Bändchendrähte zur Kontaktierung gebondet werden müssen. Darüber hinaus werden die mit dem Bonddraht zu kontaktierenden Flächen (Bondpads) mit Bändchendrähten besser abgedeckt, da es kaum zu Fußverbreiterungen kommt. Ferner können durch die flache Geometrie der Bändchendrähte niedrigere Loops geschaffen werden. Zudem sind bei vergleichbarer Loop-Geometrie die Heelschädigungen, also im empfindlichen Bogenansatz des Bonds, deutlich geringer als bei vergleichbaren Dickdrähten. Dadurch ist es möglich, unüblich hohe Stufen mit kurzen Bonds zu überbrücken und somit dicht gepackte Geometrien beim Gehäusebonden zu realisieren.

Um die vorstehend genannten Vorteile, die mit der Verwendung von Bonddrähten mit mehreren Schichten aus unterschiedlichem Material einhergehen, mit den Vorteilen, die mit der Verwendung von Bändchendrähten einhergehen, zu kombinieren, wurde vorgeschlagen, Bändchendrähte herzustellen, die eine Sandwichstruktur aufweisen.

Beispielsweise offenbart die DE 10 2006 060 899 A1 einen Bonddraht, der auf einer Seite eine lötfähige Beschichtung und auf der gegenüberliegenden Seite eine bondfähige Beschichtung aufweist.

Die DE 10 2006 025 870 A1 beschreibt ebenfalls einen Bonddraht, der sandwichartig ausgebildet ist und mindestens drei Schichten, nämlich zwei äußere Schichten und mindestens eine dazwischenliegende Schicht aufweist. Dieser Bonddraht kann im Heißwalzverfahren hergestellt werden. Dabei wird gewährleistet, dass die unterschiedlichen Schichten des Bonddrahtes ausschließlich parallel zueinander angeordnet und somit in einer Seitenansicht des Drahtes sichtbar sind.

In Versuchen hat sich jedoch herausgestellt, dass die aus dem Stand der Technik bekannten Bonddrähte mit Sandwichstruktur trotz der bisher erreichten positiven Eigenschaften auch mit verschiedenen Nachteilen behaftet sind.

So wurde beobachtet, dass beim Bonden der Bändchendrähte mit Sandwichstruktur häufig die jeweils zu verbindenden Oberflächen der Chips bzw. Substrate (Bondoberflächen) beschädigt werden. Ferner stellte sich heraus, dass beim Einsatz von Baugruppen, die derartige Bändchendrähte mit Sandwichstruktur enthalten, die Gefahr von Kurzschlüssen deutlich erhöht ist.

Der vorliegenden Erfindung lag daher die Aufgabe zugrunde, die mit der Verwendung von Bonddrähten mit mehreren Schichten aus unterschiedlichem Material einhergehenden Vorteile mit den mit der Verwendung von Bändchendrähten einhergehenden Vorteilen zu vereinigen, ohne jedoch die Nachteile herbeizuführen, die aus der Verwendung der aus dem Stand der Technik bekannten Bonddrähte mit Sandwichstruktur resultieren.

Diese Aufgabe wird erfindungsgemäß gelöst durch ein Verfahren zur Herstellung eines einen rechteckigen Querschnitt aufweisenden Bonddrahtes aufweisend einen Drahtkern aus einem ersten Material und einen den Drahtkern umhüllenden Drahtmantel aus einem zweiten Material, wobei das erste Material ein erstes Metall und das zweite Material ein zweites Metall aufweist und das erste Metall und das zweite Metall verschieden sind, wobei der Bonddraht ein Querschnittsverhältnis in Form des Verhältnisses von Breite zu Länge der rechteckigen Struktur des Querschnittes von nicht mehr als 0,8 aufweist, wobei man (i) einen Runddraht aufweisend einen Drahtkern aus einem ersten Material und einen den Drahtkern umhüllenden Drahtmantel aus einem zweiten Material bereitstellt, wobei das erste Material ein erstes Metall und das zweite Material ein zweites Metall aufweist und das erste Metall und das zweite Metall verschieden sind, und (ii) diesen Runddraht umformt, wobei beim Umformen keine Werkzeuge, die eine Gratbildung entlang der Längsseite des Drahtes hervorrufen können, zum Einsatz kommen.

Die Erfindung beruht auf der Erkenntnis, dass die beim Bonden der Bändchendrähte mit Sandwichstruktur beobachtete Beschädigung der Bondoberflächen und die beim Einsatz der mit diesen Bändchendrähten versehenen Baugruppen bestehende erhöhte Gefahr von Kurzschlüssen mit der Sandwichstruktur der Bändchendrähte in Zusammenhang stehen.

So werden zur Erzeugung dieser Sandwichstruktur Bänder aus einem ersten Material mit einem zweiten Material beschichtet. Diese Bänder werden dann üblicherweise zu entsprechenden Folien mit einer Sandwichstruktur flachgewalzt. Um schließlich Bonddrähte zu erhalten, werden diese aus den Folien mit geeigneten Schneidewerkzeugen herausgeschnitten. Dadurch erhalten die Bonddrähte entlang ihrer Längsseite, d.h. senkrecht zu ihrem Querschnitt, einen Schneidegrat. Dieser Schneidegrat ist sowohl die Ursache für Beschädigungen der Bondoberflächen beim Bondprozess als auch für Kurzschlüsse, die beim Einsatz von Baugruppen, die diese Bändchendrähte mit Sandwichstruktur enthalten, häufig zu beobachten sind.

Letztlich beruht der Schneidegrat der aus dem Stand der Technik bekannten Bändchendrähte mit Sandwichstruktur somit darauf, dass zu deren Herstellung zunächst ein Verbund mit einer

Sandwichstruktur geschaffen wird, der anschließend geschnitten werden muss, was die Bildung von Schneidegraten zur Folge hat.

Im Gegensatz dazu können die nach dem erfindungsgemäßen Verfahren hergestellten Bonddrähte, die einen Drahtkern aus einem ersten Material und einen den Drahtkern umhüllenden Drahtmantel aus einem zweiten Material aufweisen, überhaupt nicht auf diese Weise hergestellt werden. Vielmehr werden diese Bonddrähte im erfindungsgemäßen Verfahren hergestellt, indem zunächst ein entsprechender Kern-Mantel-Runddraht bereitgestellt und dieser ohne Einsatz von Schneidewerkzeugen umgeformt wird.

Mit dem erfindungsgemäßen Verfahren wird daher ein Bonddraht in Bändchenform bereitgestellt, der einen Kern aus einem ersten Material und einen den Kern umhüllenden Mantel aus einem zweiten Material aufweist, wobei das erste Material ein erstes Metall und das zweite Material ein zweites Metall aufweist und das erste Metall und das zweite Metall verschieden sind. Dieser Bonddraht weist herstellungsbedingt keine Grate auf, die zu Beschädigungen der Bondoberflächen beim Bonden oder zu Kurzschlüssen beim Betrieb der mit diesen Bonddrähten versehenen Baugruppen führen können. Dieser Bonddraht weist ferner keine offenen Kontaktstellen zwischen dem ersten Material des Kerns und dem zweiten Material des den Kern umhüllenden Mantels auf, wie dies bei Bonddrähten mit Sandwichstruktur zwangsläufig der Fall ist. Dadurch werden anders als bei den aus dem Stand der Technik bekannten Bändchendrähten mit Sandwichstruktur keine Angriffspunkte für eine Korrosion der Drähte bei der Fertigung und im Einsatz geschaffen. Darüber hinaus wird beim erfindungsgemäßen Verfahren eine Oxidation des Materials des Drahtkerns ausgeschlossen, während bei den aus dem Stand der Technik bekannten Bändchendrähten mit Sandwichstruktur die einzelnen Schichten der Sandwichstruktur Kontakt mit der Umgebungsluft haben und somit einer Oxidation zur Verfügung stehen.

Der nach dem erfindungsgemäßen Verfahren hergestellte Bonddraht weist somit einen Drahtkern aus einem ersten Material und einen den Drahtkern umhüllenden Drahtmantel aus einem zweiten Material auf.

Unter Drahtkern ist eine Struktur zu verstehen, die von dem Drahtmantel vollständig umhüllt ist.

Unter Drahtmantel ist eine Schicht zu verstehen, die den Drahtkern vollständig umhüllt. Die Dicke des Drahtmantels ist nicht weiter eingeschränkt, beträgt aber vorzugsweise wenigstens 10 nm, mehr bevorzugt wenigstens 30 nm, noch mehr bevorzugt wenigstens 250 nm, besonders bevorzugt wenigstens 500 nm, ganz besonders bevorzugt wenigstens 1 µm und insbesondere wenigstens 10 µm.

Im Rahmen der Erfindung ist der Drahtkern von dem Drahtmantel vollständig umhüllt, wenn entlang der Längsseite des Bonddrahtes das Material des Drahtkerns sich nicht an der Oberfläche des Bonddrahtes befindet, sondern von dem Drahtmantel bedeckt ist. Es kann jedoch bevorzugt sein, dass sich an den Oberflächen der Querseiten des nach dem erfindungsgemäßen Verfahren hergestellten Bonddrahtes sowohl das Material des Drahtkerns als auch das Material des Drahtmantels befindet.

Die nach dem erfindungsgemäßen Verfahren hergestellten Bonddrähte können aus dem Drahtkern und dem Drahtmantel bestehen oder neben dem Drahtkern und dem Drahtmantel wenigstens eine weitere Schicht umfassen. Von der Erfindung umfasst sind daher ebenfalls nach dem erfindungsgemäßen Verfahren hergestellte Bonddrähte, die einen Drahtkern, einen Drahtmantel und wenigstens eine weitere Schicht aufweisen, die den Drahtkern umhüllt. Diese wenigstens eine weitere Schicht kann sich zwischen dem Drahtkern und dem Drahtmantel befinden oder sowohl den Drahtkern als auch den Drahtmantel vollständig umhüllen. Somit muss der Drahtkern nicht unmittelbar mit dem Drahtmantel in Kontakt stehen. Es reicht aus, wenn der Drahtmantel den Drahtkern umhüllt, wobei es nicht darauf ankommt, ob der Drahtkern noch von weiteren Schichten umhüllt wird und wo sich diese Schichten relativ zu dem Drahtkern und dem Drahtmantel befinden. Dementsprechend ist es auch denkbar, dass der Drahtkern von mehreren Schichten umhüllt wird und somit mehrere Schichten als Drahtmantel in Betracht kommen.

Gemäß einer besonders bevorzugten Ausführungsform handelt es sich bei dem Drahtkern um eine Struktur, die eine homogene Zusammensetzung aufweist. Diese Struktur befindet sich vorzugsweise im Inneren des Bonddrahtes. Sie weist demnach vorzugsweise einen größeren Abstand zur Drahtoberfläche auf als alle anderen gegebenenfalls im Bonddraht vorhandenen Strukturen. Ferner umgibt diese Struktur vorzugsweise keine weiteren Strukturen.

Gemäß einer weiteren besonders bevorzugten Ausführungsform handelt es sich bei dem Drahtmantel um eine Schicht mit einer homogenen Zusammensetzung. Diese Schicht befindet sich vorzugsweise an der Außenseite des Bonddrahtes.

Der Drahtkern des nach dem erfindungsgemäßen Verfahren hergestellten Bonddrahts besteht aus einem ersten Material und der Drahtmantel des Bonddrahts aus einem zweiten Material. Das erste Material des Drahtkerns und das zweite Material des Drahtmantels sind dabei verschieden.

Das erste Material des Drahtkerns und das zweite Material des Drahtmantels werden vorzugsweise so ausgewählt, dass bestimmte gewünschte Eigenschaften des Bonddrahtes erhalten werden. Beispielsweise kann zur Erhöhung der Zuverlässigkeit beim Ultraschallbonden als Material für den Drahtkern Gold oder Kupfer und als Material für den Drahtmantel Aluminium eingesetzt werden. Andererseits kann zur Reduzierung von Kosten für die Herstellung des Bonddrahtes als Material für den Drahtkern Kupfer und als Material für den Drahtmantel Gold verwendet werden. Um einen oxidationsgeschützten Bonddraht zu erhalten, kann beispielsweise ein Drahtkern aus einem oxidationsempfindlichen Material, wie Kupfer, und ein Drahtmantel aus einem oxidationsunempfindlichen Material, wie Palladium, vorgesehen werden. Besonders bevorzugte Bonddrähte weisen folglich einen Drahtkern aus Kupfer und einen Drahtmantel aus Aluminium, einen Drahtkern aus Gold und einen Drahtmantel aus Aluminium, einen Drahtkern aus Kupfer und einen Drahtmantel aus Gold oder einen Drahtkern aus Kupfer und einen Drahtmantel aus Palladium auf. Daneben ist die Verwirklichung einer Vielzahl weiterer Kombinationen von Materialien für den Drahtkern und den Drahtmantel möglich, um Bonddrähte mit den für die jeweilige Anwendung gewünschten Eigenschaften herzustellen.

Das Material des Drahtkerns ist demnach hinsichtlich seiner Zusammensetzung nicht eingeschränkt. Gemäß einer bevorzugten Ausführungsform handelt es sich bei diesem Material um ein reines Metall, um eine Verbindung, um eine intermetallische Phase oder um eine Legierung. Gemäß einer besonders bevorzugten Ausführungsform handelt es sich bei dem Material des Drahtkerns um Kupfer, um eine Kupferverbindung, um eine Kupferlegierung oder um eine intermetallische Phase mit Kupfer.

Gemäß den vorstehenden Erläuterungen ist auch das Material des Drahtmantels nicht eingeschränkt. Nach einer bevorzugten Ausführungsform handelt es sich bei diesem Material ebenfalls um ein reines Metall, um eine Verbindung, um eine intermetallische Phase oder um eine Legierung. Gemäß einer besonders bevorzugten Ausführungsform handelt es sich bei dem Material des Drahtmantels um Aluminium, um eine Aluminiumverbindung (zum Beispiel Aluminiumoxid), um eine Aluminiumlegierung oder um eine intermetallische Phase mit Aluminium.

Das erste Material des Drahtkerns weist ein erstes Metall und das zweite Material des Drahtmantels ein zweites Metall auf, wobei sich das erste Metall und das zweite Metall unterscheiden.

Das erste Material des Drahtkerns enthält daher wenigstens ein erstes Metall. Dieses erste Metall kann das erste Material darstellen oder Teil einer Verbindung, einer Legierung oder einer intermetallischen Phase sein, die dieses erste Metall enthält. Gemäß einer bevorzugten Ausführungsform enthält das erste Material des Drahtkerns wenigstens 25 Gewichtsprozent und mehr bevorzugt wenigstens 50 Gewichtsprozent des ersten Metalls.

Das zweite Material des Drahtmantels enthält wenigstens ein zweites Metall. Dieses zweite Metall kann das zweite Material darstellen oder Teil einer Verbindung, einer Legierung oder einer intermetallischen Phase sein, die dieses zweite Metall enthält. Gemäß einer bevorzugten Ausführungsform enthält das zweite Material des Drahtmantels wenigstens 25 Gewichtsprozent und mehr bevorzugt wenigstens 50 Gewichtsprozent des zweiten Metalls.

Dementsprechend sind von der Erfindung nicht umfasst Verfahren zur Herstellung von Bonddrähten, die einen Drahtkern aus einem Metall und einen Drahtmantel aus einem Oxid dieses Metalls aufweisen, da das erste Material des Drahtkerns und das zweite Material des Drahtmantels keine voneinander verschiedenen Metalle aufweisen.

Andererseits sind jedoch Verfahren zur Herstellung von Bonddrähten mit einem Drahtkern aus einem ersten Metall, einer Schicht aus einem vom ersten Metall verschiedenen zweiten Metall und einer diese Schicht umgebenden Schicht aus einem Oxid dieses zweiten Metalls umfasst.

Aufgrund von Diffusionserscheinungen kann es auch bei der Herstellung bzw. der Lagerung der nach dem erfindungsgemäßen Verfahren hergestellten Bonddrähte, die einen Drahtkern aus einem ersten Material und einen den Drahtkern umhüllenden Drahtmantel aus einem zweiten Material aufweisen, zu einem Verschwinden von distinkten Grenzen zwischen dem Drahtkern und dem Drahtmantel kommen. Insbesondere ist es möglich, dass Material aus dem Drahtkern in das Material des Drahtmantels und Material aus dem Drahtmantel in das Material des Drahtkerns diffundiert. Dabei kann es zum Beispiel zur Bildung von Legierungen kommen, die sich zwischen dem Drahtkern und dem Drahtmantel befinden. Diese Legierungen bestehen zumeist aus Elementen, die in dem Material des Drahtkerns und dem Material des Drahtmantels vorkommen und weisen üblicherweise einen Gradienten auf, wobei der Gehalt an dem Element des Materials des Drahtkerns vom Inneren des Drahtes in Richtung der Oberfläche des Drahtes und der Gehalt an dem Element des Materials des Drahtmantels von der Oberfläche des Drahtes in Richtung des Inneren des Drahtes abnimmt.

Erfindungsgemäß ist es jedoch, dass der Bonddraht nicht ausschließlich aus einer einzigen homogenen Legierung oder intermetallischen Phase wenigstens zweier Materialien besteht, und dass im Bonddraht zumindest zwei Phasen enthalten sind, die den Drahtkern und den Drahtmantel bilden und unterschiedliche Metalle enthalten. Gemäß einer bevorzugten Ausführungsform beträgt der Anteil des ersten Metalls an dem ersten Material des Drahtkerns wenigstens 25 Gewichtsprozent und mehr bevorzugt wenigstens 50 Gewichtsprozent und der Anteil des zweiten Metalls an dem zweiten Material des Drahtmantels wenigstens 25 Gewichtsprozent und mehr bevorzugt wenigstens 50 Gewichtsprozent. Nach dem erfindungsgemäßen Verfahren hergestellt ist somit beispielsweise ein Draht mit (i) einem Drahtkern aus Kupfer, (ii) einer Schicht aus Aluminium, (iii) einer Schicht aus intermetallischer Phase mit Aluminium und Kupfer, die sich zwischen dem Drahtkern und der Schicht aus Aluminium befindet, und (iv) einer Schicht aus Aluminiumoxid, die die Schicht aus Aluminium umgibt.

Der nach dem erfindungsgemäßen Verfahren hergestellte Bonddraht weist ein Querschnittsverhältnis von nicht mehr als 0,8, vorzugsweise von nicht mehr als 0,6, noch mehr bevorzugt von nicht mehr als 0,5, besonders bevorzugt von nicht mehr als 0,4, ganz besonders bevorzugt von nicht mehr als 0,3 und insbesondere von nicht mehr als 0,2 auf. Das Querschnittsverhältnis liegt vorzugsweise im Bereich von 1 : 2 bis 1 : 500, noch mehr bevorzugt im Bereich von 1 : 3 bis 1 : 200, besonders bevorzugt im Bereich von 1 : 4 bis 1 : 100 und ganz besonders bevorzugt im Bereich von 1 : 5 bis 1 : 50.

Der Bonddraht weist einen rechteckigen Querschnitt auf. Das Querschnittsverhältnis ist das Verhältnis von Breite zu Länge der rechteckigen Struktur des Querschnitts. Beispielsweise weist ein Bonddraht mit einem rechteckigen Querschnitt, der die Maße 2000 µm × 200 µm besitzt, ein Querschnittsverhältnis von 0,1 auf.

Gemäß einer bevorzugten Ausführungsform des erfindungsgemäßen Verfahrens liegt der Anteil des Materials des Drahtmantels im Bereich von 5 - 50 Flächenprozent, mehr bevorzugt im Bereich von 10 - 40 Flächenprozent und noch mehr bevorzugt im Bereich von 15 - 35 Flächenprozent, bezogen auf die Querschnittsfläche des Bonddrahtes.

Gemäß einer weiteren Ausgestaltung des erfindungsgemäßen Verfahrens liegt die Dicke des Drahtmantels im Bereich von 1 : 5 bis 1 : 20 und mehr bevorzugt im Bereich von 1 : 8 bis 1 : 15, bezogen auf die Dicke des Bonddrahtes.

Der nach dem erfindungsgemäßen Verfahren hergestellte Bonddraht weist einen rechteckigen Querschnitt auf. In diesem Fall liegt die Breite der rechteckigen Struktur des Querschnitts vorzugsweise im Bereich von 10 - 500 µm, mehr bevorzugt im Bereich von 50 - 400 µm und besonders bevorzugt im Bereich von 100 - 300 µm. Die Länge der rechteckigen Struktur des Querschnitts liegt dabei vorzugsweise im Bereich von 200 - 5000 µm, mehr bevorzugt im Bereich von 400 - 4000 µm und besonders bevorzugt im Bereich von 1000 - 3000 µm.

Der Bonddraht wird nach dem erfindungsgemäßen Verfahren hergestellt, indem man zunächst einen Runddraht aufweisend einen Drahtkern aus einem ersten Material und einen den Drahtkern umhüllenden Drahtmantel aus einem zweiten Material bereitstellt, wobei das erste Material ein erstes Metall und das zweite Material ein zweites Metall aufweist und das erste Metall und das zweite Metall verschieden sind, und diesen Runddraht anschließend zu einem Bonddraht umformt, der ein Querschnittsverhältnis von nicht mehr als 0,8 aufweist.

Die Herstellung dieses Runddrahtes kann auf bekannte Weise erfolgen. Vorzugsweise wird der Runddraht mit Kern-Mantel-Struktur durch Strangpressen hergestellt. Andererseits ist es ebenfalls möglich, einen Runddraht aus einem ersten Material bereitzustellen und diesen umlaufend mit einem zweiten Material zu beschichten. Das Beschichten erfolgt in diesem Fall vorzugsweise durch Aufdampfen, Aufsputtern oder galvanisches Abscheiden des zweiten Materials. Hinsichtlich der Beschaffenheit des ersten Materials und des zweiten Materials wird auf die vorstehenden Ausführungen Bezug genommen.

Unter Runddraht wird erfindungsgemäß ein Draht verstanden, der einen im Wesentlichen runden Querschnitt aufweist. Der Runddraht weist vorzugsweise ein Querschnittsverhältnis im Bereich von 0,85 - 1,2 und insbesondere im Bereich von 0,9 - 1,1 auf. Der Durchmesser des Runddrahtes beträgt vorzugsweise 100 - 2000 µm und besonders bevorzugt 200 - 1000 µm.

Der Runddraht wird im erfindungsgemäßen Verfahren umgeformt.

Unter Umformen wird ein Vorgang verstanden, bei dem eine Veränderung der Form des behandelten Werkstücks ohne wesentliche Veränderung der Masse des behandelten Werkstücks erreicht wird. Beispielsweise handelt es sich bei einem Schneidevorgang nicht um eine Umformung, da beim Schneidevorgang die Masse des behandelten Werkstücks um die Masse des abgetrennten Schnittguts verringert wird. Beim Umformen kommen demnach keine Werkzeuge, die eine Gratbildung entlang der Längsseite des Drahtes hervorrufen können, insbesondere keine Schneidewerkzeuge, zum Einsatz. Der Runddraht wird nach dessen Bereitstellung nicht mehr geschnitten. Insbesondere wird der Runddraht beim Umformen nicht geschnitten.

Gemäß einer Ausführungsform des erfindungsgemäßen Verfahrens erfolgt das Umformen durch Flachwalzen. Die Walzbedingungen werden dabei so eingestellt, dass der Bonddraht nach dem Walzen ein Querschnittsverhältnis von nicht mehr als 0,8 aufweist.

Gemäß einer weiteren Ausführungsform des erfindungsgemäßen Verfahrens erfolgt das Umformen, indem man den Runddraht durch einen Ziehstein zieht bzw. extrudiert. Hierzu werden zunächst Ziehsteine zur Verfügung gestellt. Diese Ziehsteine weisen Öffnungen mit einer Form und einem Querschnitt auf, der der Form und dem Querschnitt, mit dem die Bonddrähte versehen werden sollen, im Wesentlichen entspricht. Dementsprechend enthält der Ziehstein Öffnungen mit einem Querschnittsverhältnis von nicht mehr als 0,8. Die genaue Geometrie der Öffnungen des Ziehsteins ist jedoch abhängig von den verwendeten Bonddrahtmaterialien. Da der Bonddraht aufgrund der Rückfederung der eingesetzten Bonddrahtmaterialien nach dem Ziehen eine Querschnittserweiterung erfahren kann, müssen in diesem Fall die Öffnungen des Ziehsteins einen kleineren Querschnitt aufweisen als der für den Bonddraht gewünschte Querschnitt. Der Draht wird schließlich durch die Öffnungen des bereitgestellten Ziehsteins gezogen und nimmt so die Form der Öffnungen des Ziehsteins an.

Nach dem Umformen können die erhaltenen Drähte, falls erforderlich, gereinigt werden. Das Reinigen erfolgt vorzugsweise mit üblichen Reinigungsmitteln und unter Anwendung üblicher Verfahren.

Die erhaltenen Bonddrähte werden vorzugsweise nach der Reinigung geglüht. Durch das Glühen können die Bonddrähte, je nach genauer Beschaffenheit, mit den gewünschten Eigenschaften versehen werden.

Anschließend können die Bonddrähte verpackt werden, beispielsweise um sie vor Oxidation und Beschädigung zu schützen.

Da für die vorstehend genannten Herstellungsverfahren als Ausgangsmaterial bereits ein Draht eingesetzt wird, der einen Drahtkern aus einem ersten Material und einen den Drahtkern umhüllenden Drahtmantel aus einem zweiten Material aufweist, und dieser Draht lediglich umgeformt wird, ist ein Schneiden dieses Drahtes nicht mehr erforderlich. Dadurch enthalten die nach dem erfindungsgemäßen Verfahren hergestellten Bonddrähte keine Grate.

Folglich können beim Bonden dieser Bonddrähte Beschädigungen der Bondoberflächen ebenso vermieden werden wie Kurzschlüsse beim Betrieb der mit diesen Bonddrähten versehenen Baugruppen.

## Patentansprüche

1. Verfahren zur Herstellung eines einen rechteckigen Querschnitt aufweisenden Bonddrahtes aufweisend einen Drahtkern aus einem ersten Material und einen den Drahtkern umhüllenden Drahtmantel aus einem zweiten Material, wobei das erste Material ein erstes Metall und das zweite Material ein zweites Metall aufweist und das erste Metall und das zweite Metall verschieden sind, wobei der Bonddraht ein Querschnittsverhältnis in Form des Verhältnisses von Breite zu Länge der rechteckigen Struktur des Querschnitts von nicht mehr als 0,8 aufweist,
**dadurch gekennzeichnet, dass** man bei dem Verfahren
(i) einen Runddraht aufweisend einen Drahtkern aus einem ersten Material und einen den Drahtkern umhüllenden Drahtmantel aus einem zweiten Material bereitstellt, wobei das erste Material ein erstes Metall und das zweite Material ein zweites Metall aufweist und das erste Metall und das zweite Metall verschieden sind, und
(ii) diesen Runddraht umformt,
wobei beim Umformen keine Werkzeuge, die eine Gratbildung entlang der Längsseite des Drahtes hervorrufen können, zum Einsatz kommen.

2. Verfahren nach Anspruch 1, **dadurch gekennzeichnet, dass** der Drahtkern aus einem Material besteht, das aus der Gruppe ausgewählt ist, die aus Kupfer, Kupferlegierungen und intermetallischen Phasen mit Kupfer besteht.

3. Verfahren nach Anspruch 1 oder 2, **dadurch gekennzeichnet, dass** der Drahtmantel aus einem Material besteht, das aus der Gruppe ausgewählt ist, die aus Aluminium, Aluminiumlegierungen und intermetallischen Phasen mit Aluminium besteht.

4. Verfahren nach einem der Ansprüche 1 - 3, **dadurch gekennzeichnet, dass** der Anteil des Materials des Drahtmantels im Bereich von 5 - 50 Flächenprozent, bezogen auf die Querschnittsfläche des Bonddrahtes, liegt.

5. Verfahren nach einem der vorhergehenden Ansprüche, **dadurch gekennzeichnet, dass** man den Runddraht umformt, indem man ihn flachwalzt.

6. Verfahren nach einem der Ansprüche 1 -4, **dadurch gekennzeichnet, dass** man den Runddraht umformt, indem man ihn durch einen Ziehstein zieht.

## Claims

1. Method for the production of a bonding wire having a rectangular cross-section, comprising a wire core made of a first material and a wire jacket made of a second material and enclosing the wire core, wherein the first material has a first metal and the second material has a second metal and the first metal and the second metal are different, wherein the bonding wire has a cross-sectional ratio, in the form of the ratio of width to length of the rectangular structure of the cross-section, of no more than 0.8, **characterized in that,** in the method,
(i) a round wire is provided, comprising a wire core made of a first material and a wire jacket made of a second material and enclosing the wire core, wherein the first material has a first metal and the second material has a second metal and the first metal and the second metal are different, and
(ii) this round wire is reshaped, wherein no tools which can cause burr formation along the longitudinal side of the wire are used upon reshaping.

2. Method according to Claim 1, **characterized in that** the wire core consists of a material selected from the group consisting of copper, copper alloys, and intermetallic phases with copper.

3. Method according to Claims 1 or 2, **characterized in that** the wire jacket consists of a material selected from the group consisting of aluminum, aluminum alloys, and intermetallic phases with aluminum.

4. Method according to any one of Claims 1 - 3, **characterized in that** the proportion of the material of the wire jacket is in the range of 5-50 percent by area in relation to the cross-sectional area of the bonding wire.

5. Method according to any one of the preceding claims, **characterized in that** the round wire is reshaped **in that** it is rolled flat.

6. Method according to any one of Claims 1 - 4, **characterized in that** the round wire is reshaped **in that** it is drawn through a drawing die.

## Revendications

1. Procédé de fabrication d'un fil de connexion présentant une section transversale rectangulaire, présentant une âme de fil en un premier matériau et une enveloppe de fil enveloppant l'âme de fil en un second matériau, le premier matériau présentant un premier métal et le second matériau présentant un second métal et le premier métal et le second métal étant différents, le fil de connexion présentant un rapport d'aspect sous la forme d'un rapport de la largeur à la longueur de la structure rectangulaire de la section transversale non supérieur à 0,8, **caractérisé en ce que,** lors du procédé
(i) un fil rond présentant une âme de fil en un premier matériau et une enveloppe de fil enveloppant l'âme de fil en un second matériau est fourni, le premier matériau présentant un premier métal et le second matériau présentant un second métal et le premier métal et le second métal étant différents et
(ii) ce fil rond est transformé, lors de la transformation, aucun outil, qui puisse entraîner des bavures le long du côté longitudinal du fil, n'étant utilisé.

2. Procédé selon la revendication 1, **caractérisé en ce que** l'âme de fil est constituée d'un matériau, qui est choisi dans le groupe constitué par le cuivre, des alliages de cuivre et des phases intermétalliques comprenant du cuivre.

3. Procédé selon la revendication 1 ou 2, **caractérisé en ce que** l'enveloppe de fil est constituée d'un matériau, qui est choisi dans le groupe constitué par l'aluminium, des alliages d'aluminium et des phases intermétalliques comprenant de l'aluminium.

4. Procédé selon l'une quelconque des revendications 1 à 3, **caractérisé en ce que** la proportion de matériau de l'enveloppe de fil se situe dans la plage de 5 à 50 pour cent de surface par rapport à la surface en section transversale du fil de connexion.

5. Procédé selon l'une quelconque des revendications précédentes, **caractérisé en ce que** le fil rond est déformé en le laminant à plat.

6. Procédé selon l'une quelconque des revendications 1 à 4, **caractérisé en ce que** le fil rond est déformé en l'étirant à travers une filière.
